Europäisches Patentamt

European Patent Office

Office européen des brevets

(11) Veröffentlichungsnummer: **0 066 802**
**A2**

(12) # EUROPÄISCHE PATENTANMELDUNG

(21) Anmeldenummer: **82104671.1**

(51) Int. Cl.³: **H 03 K 17/725**

(22) Anmeldetag: **27.05.82**

(30) Priorität: **10.06.81 DE 3123034**

(71) Anmelder: **SIEMENS AKTIENGESELLSCHAFT Berlin und München, Postfach 22 02 61, D-8000 München 22 (DE)**

(43) Veröffentlichungstag der Anmeldung: **15.12.82 Patentblatt 82/50**

(84) Benannte Vertragsstaaten: **CH DE GB LI SE**

(72) Erfinder: **Vukasovic, Lovro, Dipl.-Ing., Dresdner Strasse 8c, D-8520 Erlangen (DE)**

(54) Ansteuerschaltung für einen Thyristor.

(57) Die Erfindung betrifft eine Ansteuerschaltung für einen Thyristor (T), wobei in dessen Hauptstrompfad die Primärwicklung (Wa) eines Wandlers (W) angeordnet ist, dessen Sekundärwicklung (Wb) die Versorgungsspannung für die Ansteuerschaltung (A) abgibt. Vorteilhafterweise liegt die Sekundärwicklung (Wb) des Wandlers (W) in Reihe mit einem RC-Glied parallel zum Thyristor (T). Damit wird die Ansteuerschaltung (A) sowohl durch den über das RC-Glied fließenden Strom als auch durch den Thyristorstrom versorgt, so daß eine ausreichende Versorgung in allen Betriebsfällen sichergestellt ist. Eine Anpassung der vom Wandler abgegebenen Energie an die tatsächlich von der Ansteuerschaltung aufgenommene Energie wird erreicht, wenn die bis zur Sättigung auftretende Spannungs-Zeitfläche an den Energiebedarf der Ansteuerschaltung (A) angepaßt ist.

0066802

SIEMENS AKTIENGESELLSCHAFT
Berlin und München

Unser Zeichen
VPA 81 P 3 0 97 E

Ansteuerschaltung für einen Thyristor

Die Erfindung betrifft eine Ansteuerschaltung für einen
Thyristor, die aus dem Hauptstrompfad des Thyristors
versorgt wird, wobei dem Thyristor ein RC-Glied parallel
geschaltet ist.

Eine derartige Ansteuerschaltung ist beispielsweise aus
der DE-PS 15 38 099 bekannt. Dabei ist dem Thyristor
über einen Gleichrichter ein Speicherkondensator
parallel geschaltet, der die Ansteuerschaltung speist.
Damit kann die Energie für die Ansteuerung des Thyristors der Thyristorsperrspannung entnommen werden. Damit
treten auch bei Serienschaltung einer größeren Zahl von
Thyristoren keine Probleme mit der Potentialtrennung
von Ansteuerschaltung und Versorgungsspannungsquelle
auf. Das Steuersignal selbst kann der Ansteuerschaltung
leistungsarm, beispielsweise optisch zugeführt werden.
Diese bekannte Schaltung ist jedoch nur dann funktionsfähig, wenn sichergestellt ist, daß periodisch Sperrspannung am Thyristor ansteht. Bei ständig durchgesteuertem Thyristor reicht die Durchlaßspannung nicht
zur Versorgung der Ansteuerschaltung aus. Beispielsweise
bei Kondensator-Thyristorschaltern sollten jedoch die
Thyristoren ständig durchgeschaltet bleiben. Bei Anwendung des bekannten Prinzips zur Versorgung der Ansteuerschaltung müssen sie jedoch in jeder Periode kurz gesperrt bleiben, um den Speicherkondensator zu laden.
Damit sind jedoch Verluste in der RC-Beschaltung verbunden, die bei etwa 900 Watt pro $\mu$ F bei 3kV, 50Hz
liegen.

Sid 2 Bim / 04.06.1981

Aufgabe der Erfindung ist es daher, eine Ansteuerschaltung der eingangs genannten Art derart auszugestalten, daß keine periodische Sperrphase des Thyristors notwendig ist.

Erfindungsgemäß wird diese Aufgabe dadurch gelöst, daß im Hauptstrompfad des Thyristors die Primärwicklung eines Wandlers angeordnet ist, dessen Sekundärwicklung die Versorgungsspannung für die Ansteuerschaltung abgibt.

Dabei wird die für die Ansteuerschaltung benötigte Versorgungsenergie also nicht aus der Sperrspannung des Thyristors, sondern aus dem durch den Thyristor fließenden Strom gewonnen. Diese Schaltung bleibt also auch bei ständig durchgesteuertem Thyristor funktionsfähig. Bei gesperrtem Thyristor fließt weiterhin ein Strom über die RC-Beschaltung des Thyristors, der bei entsprechender Dimensionierung des Wandlers ausreicht, die Versorgungsenergie für die Ansteuerschaltung zu liefern.

Vorteilhafterweise kann die Sekundärwicklung des Wandlers in Reihe zum RC-Glied liegen. Damit wird der durch das RC-Glied fließende Strom direkt in die Ansteuerschaltung gespeist, wenn kein Strom durch den Thyristor fließt. In diesem Fall muß der Wandler nur den Hauptstrom übertragen und kann besser an diesen angepaßt werden.

Vorteilhafterweise ist der Wandler sättigbar, wobei die bis zur Sättigung auftretende Spannungs-Zeitfläche an den Energiebedarf der Ansteuerschaltung angepaßt ist. Damit wird auf einfachste Weise verhindert, daß die Versorgungsspannung für die Ansteuerschaltung vom Strom durch den Thyristor und von der Sperrspannung am Thyristor in weiten Bereichen nahezu unabhängig wird.

Um als zusätzlichen Schutz Überspannungen an der Ansteuerschaltung zu verhindern, kann die Sekundärwicklung des Wandlers mit einem spannungsabhängigen Widerstand überbrückt sein.

Bei einer Ansteuerschaltung für eine Thyristoranordnung mit zwei Thyristorsäulen, bei der zwei Gruppen von jeweils in Serie geschalteten Thyristoren antiparallel geschaltet sind, kann jede Thyristorsäule eine Serienschaltung von n in Verbindungspunkten miteinander verbundenen Thyristoren aufweisen, wobei alle p-ten Verbindungspunkte der Thyristorsäulen über Querverbindungen untereinander verbunden sind, wobei in jeder Thyristorsäule nach jedem eine Querverbindung aufweisenden Verbindungspunkt die Leitrichtung der Thyristoren innerhalb der Thyristorsäule wechselt und wobei die Primärwicklung jedes Wandlers in eine Querverbindung eingefügt ist. Mit dieser Thyristoranordnung erhält man eine einfache Möglichkeit zur Einfügung des Wandlers. Bei dieser Thyristoranordnung wechselt nämlich der Strom zwischen den beiden Thyristorsäulen hin und her, so daß er jeweils in den Querverbindungen abgegriffen werden kann. Die Einfügung eines Wandlers in die Thyristorsäule selbst würde dagegen deren kompakten Aufbau beeinträchtigen.

Vorteilhafterweise enthält nur jede zweite Querverbindung einen Wandler, der eine Ansteuerschaltung versorgt, die den mit dieser Querverbindung verbundenen Thyristoren gemeinsam zugeordnet ist. Da diese vier Thyristoren ein gemeinsames Potential aufweisen, kann mit dieser Art der Ansteuerung der Aufwand erheblich verkleinert werden.

Die Anordnung der RC-Glieder erfolgt dabei am besten in der Weise, daß die beiden Anschlüsse der Sekundärwicklung des Wandlers jeweils über ein RC-Glied mit den benachbarten, keinen Wandler enthaltenden Querverbindungen verbunden ist.

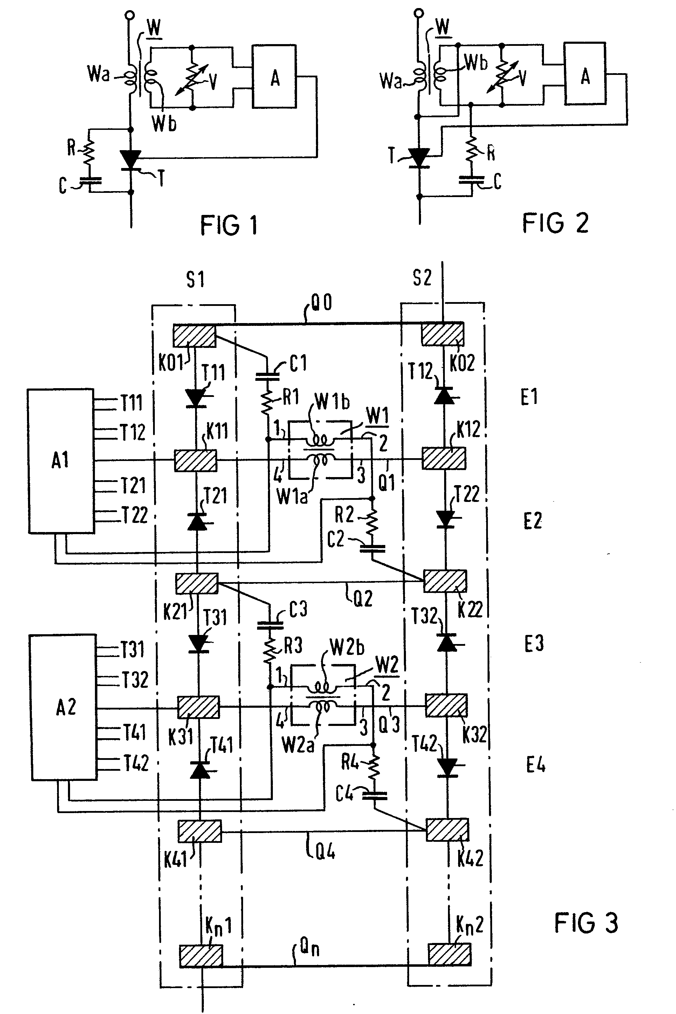

Ausführungsbeispiele der Erfindung werden nachfolgend anhand der Figuren 1 bis 5 näher erläutert.

Fig. 1 zeigt das Grundprinzip der Ansteuerschaltung für einen Thyristor T. In der Zuleitung des Thyristors liegt die Primärwicklung Wa eines Wandlers W. Die Anschlüsse der Sekundärwicklung Wb sind mit einer zu versorgenden Ansteuerschaltung A verbunden, die den Thyristor T ansteuert. Diesen Anschlüssen ist außerdem ein spannungsabhängiger Widerstand parallel geschaltet. Die Steuersignale für die Ansteuerschaltung A können beispielsweise auf optischem Weg übertragen werden, wodurch die Potentialtrennung besonders einfach wird. Die Zündelektronik für den Thyristor T kann beispielsweise analog zur Ansteuerschaltung nach der DE-PS 15 38 099 aufgebaut sein.

Wenn ein Strom durch den Thyristor T fließt, so steht an der Sekundärwicklung Wb eine Spannung an, mit der die Ansteuerschaltung A versorgt wird. Diese Spannung wird durch den spannungsabhängigen Widerstand V, der zweckmäßigerweise ein Varistor ist, begrenzt. Wenn der Thyristor T sperrt, so fließt weiterhin ein Strom über das RC-Glied R, C, der ebenfalls über den Wandler W übertragen wird und die Ansteuerschaltung A versorgt. Damit ist die Spannungsversorgung für die Ansteuerschaltung A in jedem Fall sichergestellt.

Die zur Versorgung zur Verfügung stehende Leistung ist direkt abhängig vom Übersetzungsverhältnis des Wandlers W, von dem die Primärwicklung Wa durchfließenden Strom bzw. von der am Thyristor T anstehenden Sperrspannung sowie von der Zeitdauer derselben. Wenn man aber den Wandler W sättigbar ausführt, so kann die aus dem Hauptstrompfad des Thyristors ausgekoppelte Leistung
an die von der Ansteuerschaltung A tatsächlich benötigte Leistung angepaßt werden. Es muß lediglich die
Spannungs-Zeitfläche des Wandlers W bis zu dessen
Sättigung an die Nachladespannungszeitfläche eines in
der Ansteuerschaltung enthaltenen Energiespeicherkondensators angepaßt werden.

Da der Wandler W auch dann noch genügend Leistung übertragen muß, wenn der Thyristor T sperrt und nur der
Strom durch das RC-Glied fließt, muß das Übersetzungsverhältnis auf diesen Strom ausgelegt werden. Bei dem
um mehrere Größenordnungen größeren Hauptstrom geht der
Wandler W sehr schnell in Sättigung.

Bei einer Schaltung nach Fig. 2 kann das Übersetzungsverhältnis des Wandlers W an den Hauptstrom angepaßt,
d.h. erheblich reduziert werden. Dabei liegt die
Primärwicklung Wa des Wandlers W in Reihe mit dem RC-
Glied R, C parallel zum Thyristor T. Die Zündelektronik
der Ansteuerschaltung A ist wie beim Ausführungsbeispiel
nach Fig. 1 mit den Anschlüssen der Sekundärwicklung Wb
verbunden, wobei parallel zu diesen Anschlüssen ebenfalls ein spannungsabhängiger Widerstand V liegt. Bei
diesem Ausführungsbeispiel wird bei sperrendem Thyristor T die Ansteuerschaltung A nicht über den Wandler W,
sondern mit dem an der Sekundärwicklung Wb durch die
Stromaufnahme des RC-Gliedes R, C entstehenden Spannungsabfall versorgt. Durch die Sättigung des Wandlers W
wird dabei die Spannungs-Zeitfläche ebenfalls begrenzt.

Bei Anwendung der beschriebenen Energieversorgungseinrichtung für herkömmlich aufgebaute Thyristorsäulen
müßte der erforderliche Wandler in den Säulenaufbau mit
eingefügt werden, was jedoch zu einer Vergrößerung der
Baulänge führt. Thyristoranordnungen weisen häufig zwei
antiparallel geschaltete Thyristorsäulen auf. Eine derartige Anordnung ermöglicht bei entsprechender Schaltung der Thyristoren die Unterbringung des Wandlers W außerhalb der Thyristorsäulen in Querverbindungen, wie in einem Ausführungsbeispiel nach Fig. 3 dargestellt ist. Die Thyristoranordnung nach Fig. 3 besteht aus zwei Thyristorsäulen S1 und S2, in denen jeweils Scheibenthyristoren T11 bis Tn1 bzw. T12 bis Tn2 aufeinander gestapelt sind. Zwischen zwei Scheibenthyristoren ist jeweils ein Kühlkörper K11 bis Kn1 bzw. K12 bis Kn2 eingefügt, der gleichzeitig zur elektrisch leitenden Verbindung der beiden Thyristoren dient. Die an den ersten Thyristoren T11, T12 anliegenden Kühlkörper, die gleichzeitig die Stromzuführung zu den Thyristorsäulen S1 bzw. S2 übernehmen, sind mit K01 bzw. K02 bezeichnet. Die Leitrichtung der Thyristoren innerhalb jeder Thyristorsäule S1 bzw. S2 wechselt von Thyristor zu Thyristor, d.h. an einem Kühlkörper, z.B. K11 liegen die beiden Thyristoren T11 und T21 mit ihren Kathoden an, am nächsten Kühlkörper, z.B. K21, liegen die beiden Thyristoren T21 und T31 mit ihren Anoden an. Der erste Thyristor T12 der zweiten Thyristorsäule S2 ist entgegengesetzt zum ersten Thyristor T11 der ersten Thyristorsäule S1 gepolt, so daß über die Querverbindungen Q1 bis Qn immer ein Kühlkörper, an dem die Thyristorkathoden anliegen, mit einem Kühlkörper, an dem die Thyristoranoden anliegen, verbunden ist.

Bei dieser Anordnung kann im Gegensatz zu herkömmlichen Schaltungen kein Strom über eine einzelne Thyristorsäule S1 bzw. S2 fließen, sondern der Strom wechselt über die Querverbindungen Q1 bis Qn ständig zwischen den Thyristorsäulen S1 und S2. Da somit der gesamte Thyristorstrom über die Querverbindungen Q1 bis Qn fließt, können die zur Spannungsversorgung der Ansteuerschaltungen A benötigten Wandler W in die Querverbindungen Q1 bis Qn eingefügt werden. Die Stromwandler W können dabei einfach als Ringbandkerne über eine Querverbindungsleitung Q ausgeführt werden, wobei die Querverbindungsleitung Q als Primärwicklung Wa dient. Die Sekundärwicklung Wb ist unmittelbar um den Kern gewickelt.

Da jeweils vier Thyristoren, z.B. T11 bis T22 oder T31 bis T41 einen gemeinsamen Potentialpunkt, nämlich die Kühlkörper K11 oder K31 aufweisen, kann jeweils eine Gruppe von vier Thyristoren mit einer gemeinsamen Ansteuerschaltung A1 bzw. A2 versehen sein. Damit muß nur in jede zweite Querverbindung Q1, Q3... ein Stromwandler W1, W2... eingefügt werden. Um,wie in Zusammenhang mit Fig. 1 bereits erläutert, die direkte Versorgung der Ansteuerschaltungen A durch den Strom des RC-Glieds zu ermöglichen, ist ein Anschluß der Sekundärwicklung W1b, W2b über ein RC-Glied R1, C1 bzw. R3, C3 mit einem Kühlkörper K01 bzw. K21 oder der Querverbindung Q0 bzw. Q2 und der andere Anschluß der Primärwicklung W1b über ein zweites RC-Glied R2, C2 bzw. R4, C4 mit einem zweiten Kühlkörper K22 bzw. K42 oder einer zweiten Querverbindung Q2 bzw. Q4 verbunden.

Mit einer Thyristoranordnung nach Fig. 3 kann also die Versorgungsspannung für die Ansteuerschaltungen A ohne Veränderung des Aufbaus der Thyristorsäulen lediglich durch Umpolung jedes zweiten Thyristors und Aufstecken eines Ringbandkerns auf jede zweite Querverbindungsleitung gewonnen werden.

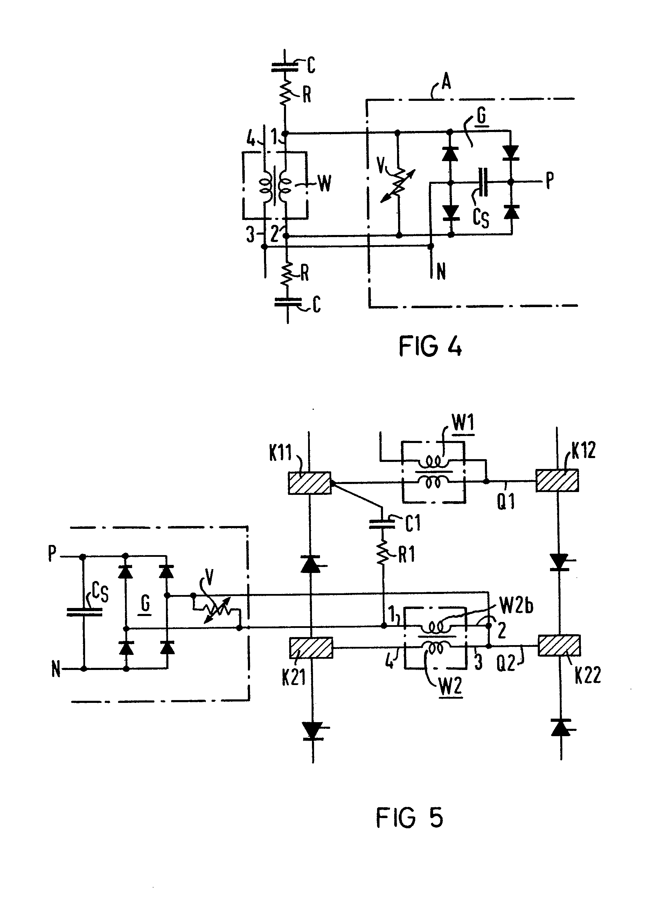

In Fig. 4 ist ein Ausführungsbeispiel für die Gleichrichtung und Speicherung der an den Klemmen 1, 2 der Sekundärwicklungen W1b, W2b abgegriffenen Spannung dargestellt. Die Klemmen 1, 2 sind mit einem Varistor überbrückt, der die anstehende Spannung begrenzt. Außerdem sind die Klemmen 1, 2 mit einem Brückengleichrichter G verbunden, dessen Gleichspannungsausgang mit einem Speicherkondensator $C_S$ überbrückt ist. Am Speicherkondensator $C_S$ kann die benötigte Versorgungsspannung abgegriffen werden, wobei ein Anschluß des Speicherkondensators $C_S$ zur Potentialfestlegung mit einer Klemme 3 des Wandlers W, also mit einer Querverbindung Q verbunden ist. Mit dieser Schaltung wird erreicht, daß der Speicherkondensator $C_S$ in jeder Halbwelle über je ein RC-Glied geladen wird, wobei die Schutzwirkung beider RC-Glieder erhalten bleibt.

In Fig. 5 ist ein Ausführungsbeispiel dargestellt, bei dem in jeder Querverbindung Q1, Q2 usw. ein Wandler W1, W2 usw. angeordnet ist. Dabei ist die Sekundärwicklung W2b einerseits über die Klemme 2 mit dem Kühlkörper K22 und über ein RC-Glied R1, C1 mit dem Kühlkörper K11 verbunden. Wie beim Ausführungsbeispiel nach Fig. 2 sind die Klemmen 1, 2 der Sekundärwicklung W2b mit einem Varistor V überbrückt und mit den Eingangsklemmen einer Brückenschaltung G verbunden. Die Potentialfestlegung erfolgt in diesem Fall durch Verbindung der Klemmen 2 und 3 der Sekundärwicklung W2b bzw. der Primärwicklung W2a mit dem Kühlkörper K22. Bei dieser Schaltungsanordnung wird der Speicherkondensator $C_S$ in beiden Halbwellen über das RC-Glied R1, C1 geladen.

Da die Stromwandler W bei allen Ausführungsbeispielen den Thyristorstrom übertragen, kann das abgegebene Signal auch zur Thyristorüberwachung ausgewertet werden.

5 Figuren
7 Patentansprüche

Patentansprüche

1. Ansteuerschaltung für einen Thyristor, die aus dem Hauptstrompfad des Thyristors versorgt wird, wobei dem Thyristor ein RC-Glied parallel geschaltet ist, d a d u r c h   g e k e n n z e i c h n e t ,   daß im Hauptstrompfad des Thyristors (T) die Primärwicklung (Wa) eines Wandlers (W) angeordnet ist, dessen Sekundärwicklung (Wb) die Versorgungsspannung für die Ansteuerschaltung (A) abgibt.

2. Ansteuerschaltung nach Anspruch 1, d a d u r c h   g e k e n n z e i c h n e t ,   daß die Sekundärwicklung (Wb) des Wandlers (W) in Reihe zum RC-Glied (R, C) liegt.

3. Ansteuerschaltung nach Anspruch 1 oder 2, d a - d u r c h   g e k e n n z e i c h n e t ,   daß der Wandler (W) sättigbar ist, wobei die bis zur Sättigung auftretende Spannungs-Zeitfläche an den Energiebedarf der Ansteuerschaltung (A) angepaßt ist.

4. Ansteuerschaltung nach einem der Ansprüche 1 bis 3, d a d u r c h   g e k e n n z e i c h n e t ,   daß die Sekundärwicklung (Wb) des Wandlers (W) mit einem spannungsabhängigen Widerstand (V) überbrückt ist.

5. Ansteuerschaltung nach einem der Ansprüche 1 bis 4, für eine Thyristoranordnung mit zwei Thyristorsäulen, bei der zwei Gruppen von jeweils in Serie geschalteten Thyristoren antiparallel geschaltet sind, d a - d u r c h   g e k e n n z e i c h n e t ,   daß jede Thyristorsäule (S1, S2) eine Serienschaltung von n in Verbindungspunkten miteinander verbundenen Thyristoren (T11 bis Tn2) aufweist, wobei alle p-ten Verbindungspunkte der Thyristorsäulen (S1, S2) über Querverbindungen (Q1 bis Qn) untereinander verbunden sind, daß in jeder Thyristorsäule (S1, S2) nach jedem eine Querverbindung (Q1 bis Qn) aufweisenden Verbindungspunkt die Leitrichtung der Thyristoren (T11 bis Tn2) innerhalb der Thyristorsäulen (S1, S2) wechselt und daß die Primärwicklung (W1a) jedes Wandlers (W1 bis Wn) in eine Querverbindung (Q1 bis Qn) eingefügt ist.

6. Ansteuerschaltung nach Anspruch 5, d a d u r c h  g e k e n n z e i c h n e t ,  daß nur jede zweite Querverbindung (Q1, Q3...) einen Wandler (W1 bis Wn) enthält, der eine Ansteuerschaltung (A) versorgt, die den mit dieser Querverbindung (Q1, Q3...) verbundenen Thyristoren (T11 bis Tn4) gemeinsam zugeordnet ist.

7. Ansteuerschaltung nach Anspruch 6, d a d u r c h  g e k e n n z e i c h n e t ,  daß die beiden Anschlüsse der Sekundärwicklung (W1b bis Wnb) des Wandlers jeweils über ein RC-Glied (R, C) mit den benachbarten, keinen Wandler enthaltenden Querverbindungen (Q0, Q2, Q4...) verbunden ist.

0066802

81 P 3097

1/2

FIG 1

FIG 2

FIG 3

0066802

81 P 3097

FIG 4

FIG 5